# EUROPÄISCHE PATENTSCHRIFT

(11) **EP 1 536 454 B1**
(45) Veröffentlichungstag und Bekanntmachung des Hinweises auf die Patenterteilung: **25.07.2012**
(21) Anmeldenummer: 04027862.4
(22) Anmeldetag: 24.11.2004
(51) Int. Cl.: C23C 14/56, H01L 21/677, H01L 21/67

(54) **Vakuumsystem**
Vacuum system
Système de vide

(30) Priorität: 28.11.2003 DE 10355678
(43) Veröffentlichungstag der Anmeldung: 01.06.2005
(73) Patentinhaber: Singulus Technologies AG, 63796 Kahl/Main (DE)
(72) Erfinder: Kempf, Stefan, 63755 Alzenau (DE); Merz, Thomas, 63739 Aschaffenburg (DE); Mücke, Michael, Dr., 61206 Wöllstadt (DE)
(74) Vertreter: Vossius & Partner

(56) Entgegenhaltungen:
- EP-A- 0 326 838
- EP-A- 0 354 294
- EP-A- 0 801 147
- EP-A1- 0 443 049
- EP-A2- 0 449 227
- CH-A- 692 741
- DE-A1- 10 048 210
- US-A1- 2002 127 852

## Beschreibung

Die Erfindung betrifft ein Vakuumsystem mit einer ersten Kammer, mindestens einer zweiten Kammer für Hochvakuum und einer dritten Kammer, durch die die erste und die zweite Kammer miteinander verbindbar sind. Insbesondere betrifft die Erfindung ein Vakuumsystem bestehend aus einer Schleuse, einer Prozeßkammer und einer Transportkammer, das für die Behandlung von Substraten vorgesehen ist, und ein Transportverfahren, das mittels des Systems durchgeführt wird. Mindestens ein Substrat wird über die Schleuse auf einen Substrathalter abgelegt, der auf einem Substratträger angeordnet ist, und durch die Transportkammer zur Prozeßkammer transportiert, wobei in der Transportkammer und in der Prozeßkammer ein Hochvakuum besteht bzw. aufrecht erhalten wird.

Derartige Vakuumsysteme sind bereits bekannt. Die DE-C1-198 06 282 offenbart eine Vorrichtung mit einer Schleuse, einer Transportkammer und einer Prozeßkammer, bei der ein Substrat über eine Schleuse auf einen Substratträger, der als Hubschwenkträger ausgebildet ist, abgelegt wird und durch die Transportkammer zur Prozeßkammer transportiert wird. Nachdem in der Schleuse ein Vorvakuum erzeugt wurde, wird der Substratträger abgesenkt, um das Substrat in die Prozeßkammer zu transportieren, wobei das Vorvakuum über den Transportraum mit dem Hochvakuum der Prozeßkammer in Verbindung kommt; der dabei auftretende Druckanstieg kann den Prozeß in der Prozeßkammer negativ beeinflussen. Ähnliche Vakuumsysteme sind auch aus der EP-B1-0 443 049 und der EP-B1-0 449 227 bekannt, bei denen die Schleuse durch einen Substrathalter abgedichtet wird, der durch einen Stößel an die Öffnung der Schleuse zur Transportkammer gedrückt wird, bis in der Schleuse Vorvakuum erzeugt ist. Die CA 692 741 A beschreibt ein Vakuumsystem entsprechend dem Oberbegriff des Anspruchs 1. Ein ähnliches Vakuumsystem ist aus der US 2002/127852 A1 bekannt.

Der Erfindung liegt die Aufgabe zugrunde, ein Vakuumsystem und ein Transportverfahren mittels dieses Systems zur Verfügung zu stellen, wobei ein Druckstoß bzw. ein Druckanstieg in einer Hochvakuumkammer beim weiteren Evakuieren einer der Hochvakuumkammer vorgeschalteten Vorvakuumkammer zuverlässig vermieden wird.

Die Aufgabe wird mit den Merkmalen der Patentansprüche 1 und 5 gelöst. Bevorzugte Ausführungsformen sind in den abhängigen Ansprüchen 2 bis 4 und 6 bis 9 definiert. Verwendungen der Vorrichtung gemäß den Ansprüchen 1 bis 4 sind in den Ansprüschen 10 bis 12 definiert. Eine bevorzugk Verwendung ist in Anspruch 13 beansprucht. Sowie des Verfahrens nach dem Ansprüchen 5 bis 9.

Bei der Lösung geht die Erfindung von folgenden Grundgedanken aus.

Wenn die erste Kammer mit der zweiten Kammer verbunden werden soll, wird das Hochvakuum in der zweiten Kammer gegen die dritte Kammer solange abgedichtet, bis die erste Kammer durch die dritte Kammer hindurch auf annähernd das gleiche Hochvakuum wie die zweite Kammer evakuiert ist. Insbesondere beim Einlegen eines Substrats in eine Schleuse (erste Kammer) verschließen in einer Transportkammer (dritte Kammer) ein erster und ein zweiter Substrathalter auf einem Hubschwenkarm-Substratträger sowohl eine Prozeßkammer (zweite Kammer) als auch die Schleuse. Die Substrathalter sind bewegbar z.B. über Zugfedern mit dem Substratträger verbunden. Nach dem Evakuieren der Schleuse auf Vorvakuum wird der Substratträger mit dem zweiten Substrathalter an der Schleuse um eine definierte Spaltbreite abgesenkt, so daß das Gasvolumen aus der Schleuse in das Hochvakuum der Transportkammer expandieren kann, wo es durch eine Hochvakuumpumpe abgesaugt wird. Gleichzeitig wird der erste Substrathalter mit einem zu behandelnden Substrat an der Prozeßkammer durch eine Halteeinrichtung die einen Stößel aufweist, an der Öffnung der Prozeßkammer fixiert. Der Substratträger bewegt sich um die definierte Spaltbreite gegen die Kraft z.B. der Zugfedern von dem ersten Substrathalter weg, der an der Prozeßkammer bleibt und somit das Hochvakuum in der Prozeßkammer gegen die Transportkammer abdichtet, so daß in der Prozeßkammer kein Druckanstieg auftritt, wenn das Gasvolumen der Schleuse in die Transportkammer expandiert. Erst wenn in der Transportkammer annähernd das gleiche Hochvakuum wie in der Prozeßkammer vorhanden ist, wird z.B. der Stößel vom ersten Substrathalter an der Prozeßkammer gelöst. Der erste Substrathalter mit dem behandelten Substrat bewegt sich z.B. durch die Kraft der Federn und/oder die Schwerkraft auf den Substratträger zurück und kann zur Schleuse transportiert werden, wobei in entgegengesetzter Richtung der zweite Substrathalter mit einem zu behandelnden Substrat von der Schleuse zur Prozeßkammer transportiert wird.

Der Vorteil der Erfindung liegt in stabileren Prozeßbedingungen und einer Verbesserung der Qualität bei empfindlichen Beschichtungsprozessen, z.B. für CDs, DVDs, optischen Linsen und Brillengläsern oder bei der Ionenbestrahlung von Harddisk-Scheiben (insbesondere für Festplattenspeichermedien).

Im folgenden wird die Erfindung anhand der Zeichnung näher erläutert. Es zeigen:
- Figur 1: einen Querschnitt durch eine erfindungsgemäße Ausführungsform, wobei die Verbindung zwischen der Transportkammer einerseits und der Schleuse und einer Hochvakuumkammer (z.B. Prozeßkammer) andererseits geschlossen ist, und
- Figur 2: die Ausführungsform gemäß Figur 1, wobei die Verbindung zwischen der Schleuse und der Transportkammer geöffnet ist.

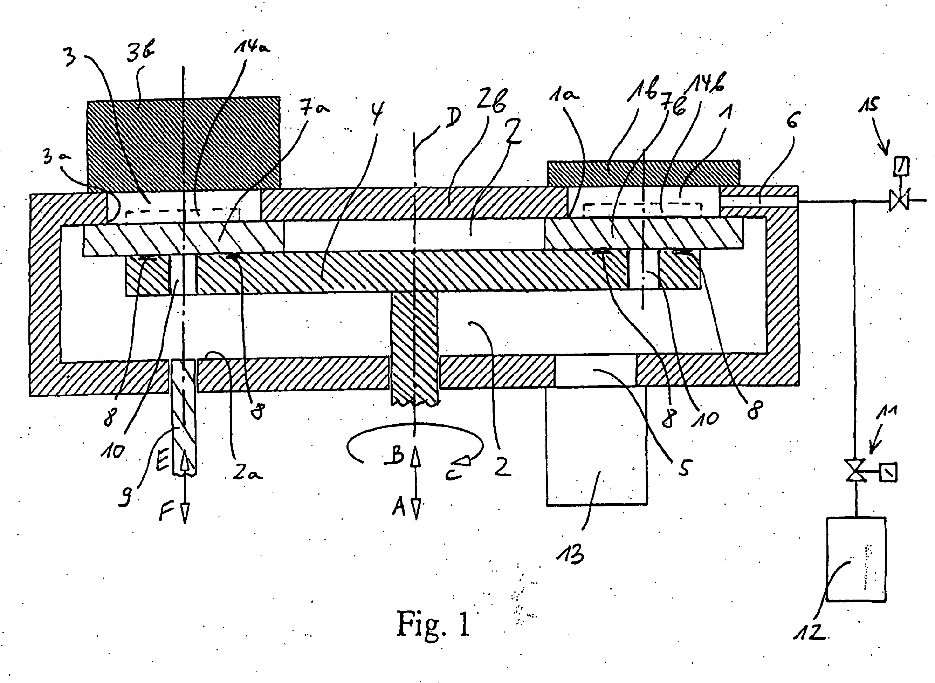

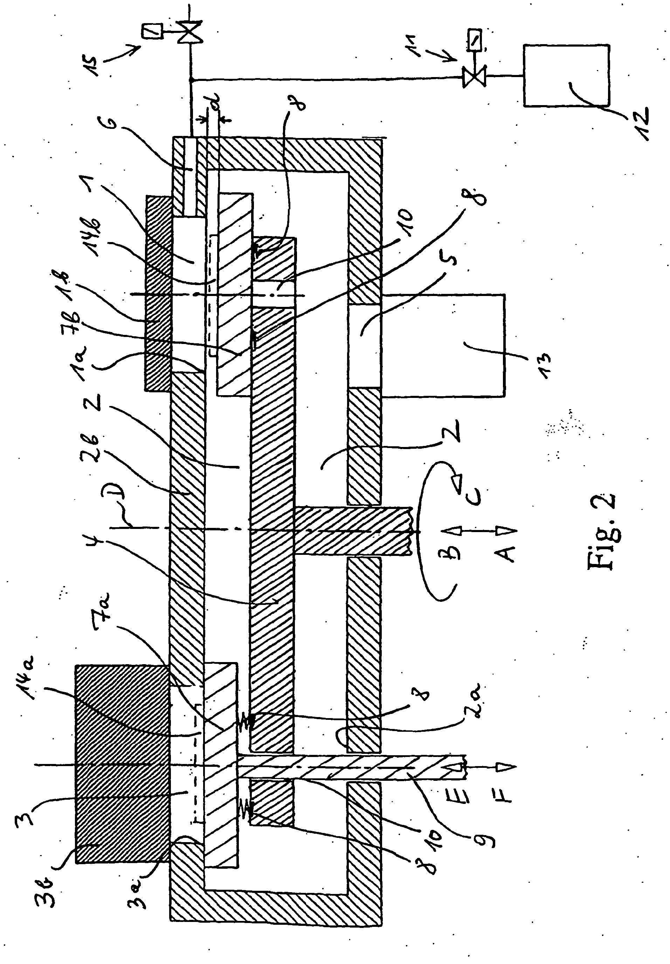

Die Figuren 1 und 2 zeigen Querschnitte einer Ausführungsform des erfindungsgemäßen Vakuumsystems, das z.B. für die einseitige Behandlung von Substraten geeignet ist. Die erfindungsgemäße Ausführungsform weist eine Schleuse 1, eine Transportkammer 2 und eine Prozeßkammer 3 auf, an deren Öffnung 3a eine Prozeßeinrichtung 3b, z.B. Kathodenzerstäubungseinrichtung, Ionenkanone oder CVD-Beschichtungseinrichtung, angeordnet ist. In der Transportkammer 2 ist ein Hubschwenkarm-Substratträger 4 angeordnet, der einen ersten und einen zweiten Substrathalter 7a bzw. 7b trägt und längs der Schwenkachse D, d.h. in Richtung der Pfeile A und B, absenkbar und anhebbar ist, sowie in Schwenkrichtung C um die Schwenkachse D zwischen der Schleuse 1 und der Prozeßkammer 3 schwenkbar ist. Die Substrathalter 7a, 7b sind mittels Zugfedern 8, z.B. Membranfedern, an dem Substratträger 4 bewegbar angeordnet. Die Schleusenöffnung 1a der Schleuse 1 ist mit einem Deckel 16 verschlossen und kann über einen Kanal 6 durch eine Vorvakuumpumpe 12 evakuiert oder über ein Ventil 15 belüftet werden. Die Transportkammer 2 hat einen Hochvakuumpumpenanschluß 5, der vorzugsweise mit einer Turbomolekularpumpe 13 zum Evakuieren der Transportkammer 2 und der Prozeßkammer 3 verbunden ist. Im Substratträger 4 (in den Figuren unterhalb der Substrathalter 7a und 7b) sind Öffnungen 10 angeordnet, durch die ein Stößel 9 an den Substrathalter 7a bzw. 7b herangefahren werden kann, um den Substrathalter 7a mit dem Substrat 14a an der Prozeßkammer 3 zu positionieren bzw. zu fixieren. Zwischen dem Substratträger 4, den Substrathaltern 7a bzw. 7b, und der Wand 2b der Transportkammer 2 sowie zwischen dem Schleusendeckel 1b und der Wand 2b der Transportkammer 2 sind Vakuumdichtungen (nicht dargestellt) angeordnet.

Die Arbeitsweise des erfindungsgemäßen Systems wird im folgenden anhand der Figuren 1 und 2 näher erläutert.

Nach Abheben des Deckels 1b von der Schleuse 1 wird ein Substrat 14b auf dem zweiten Substrathalter 7b, der die Schleuse 1 von der Transportkammer 2 trennt, abgelegt. Danach wird die Schleuse 1 mit dem Deckel 1b wieder verschlossen. Die Schleuse wird über den Kanal 6 durch die Vorvakuumpumpe 12 evakuiert, wobei das Ventil 11 vor der Vorvakuumpumpe 12 geöffnet und das Belüftungsventil 15 geschlossen ist. Während dieses Vorgangs liegt der erste Substrathalter 7a an der Prozeßkammer 3 an und verschließt die Prozeßkammeröffnung 3a, wobei das Substrat 14a, das sich auf dem Substrathalter 7a befindet, durch verschiedene Prozesse z.B. durch Metallisieren an der Oberfläche durch Kathodenzerstäubung oder CVD-Behandlung oder durch Behandlung mittels einer Ionenkanone entsprechend behandelt werden kann. Dieser Zustand ist in Figur 1 dargestellt.

Vorzugsweise befindet sich in der Prozeßkammer 3 z.B. eine Zerstäubungskathode zur Beschichtung des Substrats. Die Prozeßkammer 3 kann aber auch eine Einrichtung zum Reinigen der Substratoberfläche, z.B. durch Sputterätzen oder eine Ionenkanone enthalten.

Gemäß Fig. 2 ist durch die Öffnung 10 des Substratträgers 4 der Stößel 9 in Richtung des Pfeils E an die Unterseite des ersten Substrathalters 7a herangefahren, so daß er den Substrathalter 7a in seiner Position fixiert bzw. unterstützt. Wenn das Vorvakuum in der Schleuse etwa 0,1 bis 3 mbar, vorzugsweise 1 mbar beträgt, wird der Substratträger 4 längs der Schwenkachse D in Pfeilrichtung A um eine Spaltbreite d zwischen der Schleusenöffnung 1a und dem zweiten Substrathalter 7b abgesenkt. Dabei bleibt der erste Substrathalter 7a, da er durch den Stößel 9 unterstützt ist, an der Öffnung 3a der Prozeßkammer 3, während der Substratträger 4 gegen die Kraft der Federn 8 abgesenkt wird, wobei sich die Federn, die vorzugsweise Membranfedern sind, ausdehnen und somit die Bewegung des Substratträgers 4 gegenüber dem ersten Substrathalter 7a ermöglichen. Über den so entstehenden Spalt mit der Spaltbreite d, die 1 bis 5 mm betragen kann, expandiert das Gasvolumen aus der Schleuse 1 in die Transportkammer 2 und wird dort über den Anschluß 5 durch die Hochvakuumpumpe 13, die vorzugsweise eine Turbomolekularpumpe ist, abgesaugt. Dieser Zustand ist in Figur 2 dargestellt.

Da die Prozeßkammer 3 während des Gaseintritts aus der Schleuse 1 in die Transportkammer 2 durch den ersten Substrathalter 7a verschlossen bleibt, kann sich das Restgas der Schleuse 1 nicht in die Prozeßkammer 3 ausbreiten, sondern wird durch die Hochvakuumpumpe 13 abgepumpt. Dadurch kann in der Prozeßkammer 3 ein sehr stabiler Prozeß durchgeführt und die Schichtqualität bei den verschiedenen Behandlungsprozessen, z.B. bei der Beschichtung von CDs und DVDs verbessert werden. Wenn das Hochvakuum in der Transportkammer 2 annähernd den gleichen Wert wie in der Prozeßkammer 3 erreicht hat, wird der Stößel 9 in Richtung des Pfeiles F vom Substrathalter 7a durch die Öffnung 10 bis zum Boden 2a der Transportkammer 2 zurückgezogen. Da zwischen der Prozeßkammer 3 und der Transportkammer 2 kein Druckunterschied mehr besteht, wird der Substrathalter 7a durch die Schwerkraft und insbesondere die Zugkraft der Federn 8 auf den Substratträger 4 abgesenkt, so daß beide Substratträger 7a, 7b mit den Substraten 14a bzw. 14b nicht mehr an den Öffnungen 3a bzw. 1a anliegen. Danach wird das in der Prozeßkammer 3 behandelte Substrat 14a durch eine Schwenkbewegung des Substratträgers 4 in Richtung des Pfeiles C um die Achse D zur Schleuse 1 transportiert und das zu behandelnde Substrat 14b auf dem zweiten Substrathalter 7b zur Prozeßkammer 3 transportiert. Durch eine Hubbewegung des Substratträgers 4 in Richtung B längs der Achse D wird der erste Substratträger 7a mit dem behandelten Substrat 14a gegen die Öffnung 1b der Schleuse 1 gedrückt und der zweite Substrathalter 7b mit dem zu behandelnden Substrat 14b gegen die Öffnung 3a der Prozeßkammer 3 gedrückt; danach erfolgt die Behandlung des Substrats 14b. Gleichzeitig wird die Schleuse 1 über den Kanal 6 und über das Ventil 15 belüftet, wobei das Ventil 11 vor der Vorvakuumpumpe 12 geschlossen bleibt. Danach wird der Deckel 1a von der Schleuse 1 abgehoben und das behandelte Substrat 14a wird von dem ersten Substrathalter 7a entnommen.

Der Substratträger 4 kann mehr als zwei Substrathalter auf einem Drehteller 4 mit jeweils z.B. 120 oder 90° Abstand aufweisen, wobei jeder Substrathalter auf einer Öffnung 10 in dem Substratträger 4 für den Stößel 9 angeordnet und über Zugfedern 8 mit dem Substratträger 4 verbunden ist. Der Substrathalter kann auch so konstruiert sein, daß er mehrere Substrate trägt, so daß mehr Substrate gleichzeitig in der Prozeßkammer 3 behandelt werden können.

In der in den Figuren 1 und 2 dargestellten Ausführungsform erfolgt der Transport des Substrats von der Schleuse zur Prozeßkammer durch eine Drehbewegung des Substratträgers um 180°. Das Substrat kann aber auch bei entsprechend angeordneter Schleuse und Prozeßkammer durch eine Drehbewegung um einen kleineren Winkel z.B. 120 oder 90° transportiert werden. Des weiteren ist ein Transport des Substrats auch durch eine Linearbewegung eines Substratträgers zwischen der Schleuse und der Prozeßkammer möglich.

Das erfindungsgemäße Vakuumsystem kann auch bei der Oberflächenbehandlung von Harddisk-Scheiben mittels einer Ionenkanone zum Einsatz kommen. Darüber hinaus kann es allgemein auch bei anderen Hochvakuumprozessen eingesetzt werden. '

## Patentansprüche

1. Vakuumsystem mit:
(a) einer ersten Kammer (1);
(b) mindestens einer zweiten Kammer (3) für Hochvakuum;
(c) einer dritten Kammer (2) zum Verbinden der ersten Kammer (1) und der zweiten Kammer (3); wobei
(d) die dritte Kammer (2) so ausgebildet ist, daß sie das Hochvakuum der zweiten Kammer (3) gegen die dritte Kammer (2) abdichtet, wenn die erste Kammer (1) über die dritte Kammer (2) von Vorvakuum auf Hochvakuum evakuiert wird
(e) dritte Kammer als Transportkammer (2) ausgebildet ist, in der eine Transporteinrichtung (4) zum Transportieren mindestens eines Substrats (14a bzw. 14b) von der ersten Kammer (1) in die zweite Kammer (3) und umgekehrt angeordnet ist ;
(f) die erste Kammer als eine Schleuse (1) und die zweite Kammer als eine Prozeßkammer (3) ausgebildet ist.
(g) die Transportkammer (2) an einer Schleusenöffnung (1a) und einer Prozeßkammeröffnung (3a) angeordnet ist;
(h) die Schleuse (1) einen Deckel (1b) zum Verschließen der Schleusenöffnung (1a) aufweist ; **dadurch gekennzeichnet, daß**
(i) die Transporteiwichtung ein als Hub-Schwenkträger ausgebildeter Substratträger (4) ist, der zwischen der Schleuse (1) und der Prozeßkammer (3) in Schwenkrichtung (C) und in Richtung (A, B) längs der Schwenkachse (D) hin und her bewegbar ist;
(j) in der Transportkammer (2) ein Hochvakuumpumpenanschluß (5) vorgesehen ist;
(k) in der Schleuse (1) ein Belüfrungs-Vorvakuumpumpenkanal (6) vorgesehen ist;
(l) mindestens ein erster und ein zweiter Substrathalter (7a bzw. 7b) vorgesehen sind, die mit dem Substratträger (4) bewegbar verbunden sind; und
(m) in der Transportkammer (2) eine Halteeinrichtung (9) angeordnet ist, um den Substrathalter (7a, 7b) an der Prozeßkammeröffnung (3a) zu fixieren
, wobei die Halteeinrichtung einen Stößel (9) aufweist, der durch eine Öffnung (10) im Substratträger (4) an den Substrathalter (7a, 7b) heranfahrbar ist, um den an der Prozeßkammer (3) anliegenden Substrathalter (7a bzw. 7b) an der Prozeßkammeröffnung (3a) zu halten, und die Prozeßkammer (3) verschlossen zu halten, wenn der Substratträger (4) in Richtung (A) der Schwenkachse (D) von der Prozeßkammer (3) wegbewegt wird.

2. Vakuumsystem nach Anspruch 1, wobei der erste und der zweite Substrathalter (7a bzw. 7b) jeweils über Zugfedern (8) mit dem Substratträger (4) verbunden sind.

3. Vakuumsystem nach Anspruch 2, wobei die Federn (8) Membranfedern sind.

4. Vakuumsystem nach einem der Ansprüche 1 bis 3, wobei der Hochvakuumpumpenanschluß (5) an eine Turbomolekularpumpe (13) angeschlossen ist.

5. Verfahren zum Transport eines Objekts im Vakuum zwischen einer Schleuse und einer Prozeßkammer, insbesondere mittels des Systems nach einem der Ansprüche 1 bis 4 mit den Schritten:
(a) Einlegen mindestens eines Substrats (14b) auf den zweiten Substrathalter (7b) in der Schleuse (1) in einer Stellung (B) des Substratträgers (4), wobei die Transportkammer (2) durch den zweiten Substrathalter (7b) verschlossen ist und der erste Substrathalter (7a) mit einem Substrat (14a) die Prozeßkammer (3) verschließt;
(b) Verschließen der Schleuse (1) durch den Deckel (1b);
(c) Evakuieren der Schleuse (1) auf Vorvakuum durch eine Vorvakuumpumpe (12) über den Kanal (6);
(d) vor, während oder nach den Verfahrensschritten (a), (b) oder (c): Heranfahren des Stößels (9) durch die Öffnung (10) an den die Prozeßkammer (3) verschließenden ersten Substrathalter (7a);
(e) Absenken des Substratträgers (4) mit dem zweiten Substrathalter (7b) um eine definierte Spaltbreite (d) zur Schleusenöffnung (1a), so daß das Gasvolumen aus der Schleuse (1) in die Transportkammer (2) expandieren kann, wobei der erste Substrathalter (7a) durch den Stößel (9) an der Öffnung (3a) gehalten wird;
(f) Evakuieren der Transportkammer (2) auf Hochvakuum über den Hochvakuumpumpenanschluß (5);
(g) Lösen des Stößels (9) von dem ersten Substrathalter (7a) und aus einer Öffnung (10), wenn in der Transportraumkammer (2) annähernd das gleiche Hochvakuum wie in der Prozeßkammer (3) erreicht ist, wobei der erste Substrathalter (7a) sich von der Prozeßkammeröffnung (3a) entfernt und auf den Substratträger (4) aufsetzt;
(h) Transportieren des ersten Substrathalters (7a) mit dem behandelten Substrat (14a) zur Schleuse (1) und des zweiten Substrathalters (7b) mit dem zu behandelnden Substrat (14b) zur Prozeßkammer (3);
(i) Heranfahren der Substrathalter (7a bzw. 7b) an die Schleusenöffnung (1a) bzw. die Prozeßkammeröffnung (3a);
(j) Belüften der Schleuse (1) durch ein Ventil (15) über den Kanal (6);
(k) Öffnen des Schleusendeckels (1a); und
(l) Entnehmen des Substrats (14a).

6. Verfahren nach Anspruch 5 wobei die Spaltbreite (d) 1 bis 5 mm beträgt.

7. Verfahren nach Anspruch 5 oder 6, wobei in der Schleuse (1) ein Vorvakuum von 0,1 bis 3 mbar erzeugt wird.

8. Verfahren nach Anspruch 7, wobei in der Schleuse (1) ein Vorvakuum von 1 mbar erzeugt wird.

9. Verfahren nach einem der Ansprüche 5 bis 8 wobei der Substrathalter (7a bzw. 7b) gegen die Kraft der Zugfedern (8) an der Öffnung (3a) gehalten wird und nach Zurückziehen des Stößels (9) durch die Zugfedern (8) auf den Substratträger (4) zurückgezogen wird.

10. Verwendung des Vakuumsystems nach einem der Ansprüche 1 bis 4 und des Verfahrens nach einem der Ansprüche 5 bis 9 bei der Beschichtung von CDs, DVDs, optischen Linsen und Brillengläsern.

11. Verwendung des Vakuumsystems nach einem der Ansprüche 1 bis rund des Verfahrens nach einem der Ansprüche 5 bis 9 bei der Reinigung von CDs und DVDs.

12. Verwendung des Vakuumsystems nach einem der Ansprüche 1 bis 4 und des Verfahrens nach einem der Anspruche 5 bis 9 bei der Oberflächenbehandlung durch Ionenbestrahlung.

13. Verwendung nach Anspruch 12 bei der Oberflächenbehandlung von Harddisk-Scheiben.

## Claims

1. A vacuum system comprising:
(a) first chamber (1);
(b) at least a second chamber (3) for high vacuum;
(c) a third chamber (2) for connecting the first chamber (1) and the second chamber (3); wherein
(d) the third chamber (2) is configured such that it seals the high vacuum of the second chamber (3) against the third chamber (2) when the first chamber (1) is evacuated via the third chamber (2) from pre-vacuum to high vacuum;
(e) the third chamber is configured as transport chamber (2) in which a transport means (4) is arranged for transporting at least one substrate (14a and/or 14b) from the first chamber (1) into the second chamber (3) and vice versa;
(f) the first chamber is configured as a lock (1) and the second chamber as a process chamber (3);
(g) the transport chamber (2) is arranged at a lock opening (1a) and a process chamber opening (3a);
(h) the lock (1) comprises a cover (1b) for closing the lock opening (1a);
**characterized in that**
(i) the transport means is a substrate carrier (4) which is configured as a lifting and swiveling carrier and can be moved to and fro between the lock (1) and the process chamber (3) in the swiveling direction (C) and in the direction (A, B) along the swiveling axis (D);
(j) a high vacuum pump connection (5) is provided in the transport chamber (2);
(k) a pre-vacuum pump channel (6) for venting is provided in the lock (1);
(l) at least a first and a second substrate holder (7a and 7b) are provided, which are movably connected with the substrate carrier (4); and
(m) a holding means (9) is arranged in the transport chamber (2) for fixing the substrate holder (7a, 7b) to the process chamber opening (3a),
wherein the holding means comprises a plunger (9) which can be moved through an opening (10) in the substrate carrier (4) towards the substrate holder (7a, 7b) in order to hold the substrate holder (7a and/or 7b) adjoining the process chamber (3) at the process chamber opening (3a) and to keep the process chamber (3) closed when the substrate carrier (4) is moved in the direction (A) of the swiveling axis (D) away from the process chamber (3).

2. The vacuum system according to claim 1, wherein the first and the second substrate holder (7a and 7b) are connected with the substrate carrier (4) via respective tensile springs (8).

3. The vacuum system according to claim 2, wherein the springs (8) are membrane springs.

4. The vacuum system according to any one of claims 1 to 3, wherein the high vacuum pump connection (5) is connected to a turbo molecular pump (13).

5. A method for transporting an object in a vacuum between a lock and a process chamber, in particular by using the system according to any one of claims 1 to 4, comprising the steps of:
(a) inserting at least one substrate (14b) in the second substrate holder (7b) in the lock (1) in a position (B) of the substrate carrier (4), wherein the transport chamber (2) is closed by the second substrate holder (7b) and the first substrate holder (7a) with a substrate (14a) closes the process chamber (3);
(b) closing the lock (1) by means of the cover (1b);
(c) evacuating the lock (1) to pre-vacuum by a pre-vacuum pump (12) via the channel (6);
(d) prior to, during or after method step (a), (b) or (c): moving the plunger (9) through the opening (10) to the first substrate holder (7a) closing the process chamber (3);
(e) lowering the substrate carrier (4) with the second substrate holder (7b) by a defined gap width (d) towards the lock opening (1a) so that the gas volume can expand from the lock (1) into the transport chamber (2), wherein the first substrate holder (7a) is held by the plunger (9) at the opening (3a);
(f) evacuating the transport chamber (2) to high vacuum via the high vacuum pump connection (5);
(g) releasing the plunger (9) from the first substrate holder (7a) and out of an opening (10) when approximately the same high vacuum as in the process chamber (3) has been reached in the transport chamber (2), wherein the first substrate holder (7a) moves away from the process chamber opening (3a) and contacts the substrate carrier (4);
(h) transporting the first substrate holder (7a) with the treated substrate (14a) to the lock (1) and the second substrate holder (7b) with the substrate (14b) to be treated to the process chamber (3);
(i) moving the substrate holders (7a and 7b) towards the lock opening (1a) and the process chamber opening (3a), respectively;
(j) venting the lock (1) through a valve (15) via the channel (6);
(k) opening the lock cover (1a); and
(l) removing the substrate (14a).

6. The method according to claim 5, wherein the gap width (d) is 1 to 5 mm.

7. The method according to claim 5 or 6, wherein a pre-vacuum of 0.1 to 3 mbar is generated in the lock (1).

8. The method according to claim 7, wherein a pre-vacuum of 1 mbar is generated in the lock (1).

9. The method according to any one of claims 5 to 8, wherein the substrate holder (7a and/or 7b) is held at the opening (3a) against the force of the tensile springs (8) and after removal of the plunger (9) is drawn back to the substrate carrier (4) by the tensile springs (8).

10. Use of the vacuum system according to any one of claims 1 to 4 and the method according to any one of claims 5 to 9 for coating CDs, DVDs, optical lenses and eyeglass lenses.

11. Use of the vacuum system according to any one of claims 1 to 4 and the method according to any one of claims 5 to 9 for cleaning CDs and DVDs.

12. Use of the vacuum system according to any one of claims 1 to 4 and the method according to any one of claims 5 to 9 for the surface treatment by ion irradiation.

13. The use of claim 12 for the surface treatment of hard disks.

## Revendications

1. Système de vide, comportant :
(a) une première chambre (1) ;
(b) au moins une deuxième chambre (3) pour un vide élevé ;
(c) une troisième chambre (2) permettant de relier la première chambre (1) à la deuxième chambre (3) ; où
(d) la troisième chambre (2) est réalisée de manière à assurer l'étanchéité du vide élevé de la deuxième chambre (3) par rapport à la troisième chambre (2), quand la première chambre (1) est passée d'un pré-vide à un vide élevé via la troisième chambre (2),
(e) la troisième chambre est réalisée comme chambre de transport (2) où est prévu un dispositif de transport (4) destiné au transport d'au moins un substrat (14a, 14b) de la première chambre (1) vers la deuxième chambre (3) et inversement,
(f) la première chambre est réalisée comme un sas (1) et la deuxième chambre comme une chambre de processus (3),
(g) la chambre de transport (2) est disposée contre une ouverture de sas (1a) et une ouverture de chambre de processus (3a) ;
(h) le sas (1) comporte un couvercle (1b) pour la fermeture de l'ouverture de sas (1a),
caractérisé
(i) en ce que le dispositif de transport est un support de substrat (4) réalisé comme support élévateur-pivotant, lequel est déplaçable en va-et-vient entre le sas (1) et la chambre de processus (3) dans la direction de pivotement (C) et dans la direction (A, B) le long de l'axe de pivotement (D) ;
(j) en ce qu'un raccord de pompe à vide élevé (5) est prévu dans la chambre de transport (2) ;
(k) en ce qu'un canal d'aération de pompe à pré-vide (6) est prévu dans le sas (1) ;
(l) en ce qu'au moins un premier et un deuxième maintien de substrat (7a, 7b) sont prévus, lesquels sont raccordés de manière mobile au support de substrat (4) ; et
(m) en ce qu'un dispositif de maintien (9) est disposé dans la chambre de transport (2) pour fixer le maintien de substrat (7a, 7b) contre l'ouverture de chambre de processus (3a),
le dispositif de maintien comportant un poussoir (9) qui peut être avancé contre le maintien de substrat (7a, 7b) par une ouverture (10) dans le support de substrat (4), pour maintenir contre l'ouverture de chambre de processus (3a) le maintien de substrat (7a, 7b) appliqué sur la chambre de processus (3), et maintenir fermée la chambre de processus (3) quand le support de substrat (4) est éloigné de chambre de processus (3) dans la direction (A) de l'axe de pivotement (D).

2. Système de vide selon la revendication 1, où le premier et le deuxième maintien de substrat (7a, 7b) sont raccordés au support de substrat (4) par des ressorts de traction (8) respectifs.

3. Système de vide selon la revendication 2, où les ressorts (8) sont des ressorts à membrane.

4. Système de vide selon l'une des revendications 1 à 3, où le raccord de pompe à vide élevé (5) est raccordé à une pompe turbomoléculaire (13).

5. Procédé de transport d'un objet dans le vide entre un sas et une chambre de processus, en particulier au moyen du système selon l'une des revendications 1 à 4, comprenant les étapes suivantes :
(a) mise en place d'au moins un substrat (14b) sur le deuxième maintien de substrat (7b) dans le sas (1), dans une position (B) du support de substrat (4) où la chambre de transport (2) est fermée par le deuxième maintien de substrat (7b), et où le premier maintien de substrat (7a) ferme la chambre de processus (3) avec un substrat (14a) ;
(b) fermeture du sas (1) par le couvercle (1b)
(c) obtention d'un pré-vide dans le sas (1) au moyen d'une pompe à pré-vide (12) par l'intermédiaire du canal (6) ;
(d) avant, pendant ou après les étapes de processus (a), (b) ou (c) : avance du poussoir (9) par l'ouverture (10) contre le premier maintien de substrat (7a) fermant la chambre de processus (3) ;
(e) abaissement du support de substrat (4) avec le deuxième maintien de substrat (7b), d'une largeur de fente (d) définie vers l'ouverture de sas (1a), de manière à permettre l'expansion du volume gazeux hors du sas (1) dans la chambre de transport (2), le premier maintien de substrat (7a) étant maintenu contre l'ouverture (3a) par le poussoir (9) ;
(f) obtention d'un vide élevé dans la chambre de transport (2) au moyen du raccord de pompe à vide élevé (5) ;
(g) desserrage du poussoir (9) du premier maintien de substrat (7a) et hors d'une ouverture (10), quand le même vide élevé est sensiblement obtenu dans la chambre de transport (2) que dans la chambre de processus (3), le premier maintien de substrat (7a) s'éloignant de l'ouverture de chambre de processus (3a) et s'appliquant sur le support de substrat (4) ;
(h) transport du premier maintien de substrat (7a) avec le substrat traité (14a) vers le sas (1), et du deuxième maintien de substrat (7b) avec le substrat à traiter (14b) vers la chambre de processus (3) ;
(i) avance des maintiens de substrat (7a, 7b) contre l'ouverture de sas (1a) ou l'ouverture de chambre de processus (3a) ;
(j) aération du sas (1) par une vanne (15) via le canal (6) ;
(k) ouverture du couvercle de sas (1a) ; et
(l) retrait du substrat (14a).

6. Procédé selon la revendication 5, où la largeur de fente (d) est comprise entre 1 et 5 mm.

7. Procédé selon la revendication 5 ou la revendication 6, où un pré-vide de 0,1 à 3 mbar est généré dans le sas (1).

8. Procédé selon la revendication 7, où un pré-vide de 1 mbar est généré dans le sas (1).

9. Procédé selon l'une des revendications 5 à 8, où le maintien de substrat (7a, 7b) est maintenu sur l'ouverture (3a) contre la force des ressorts de traction (8) et est rappelé sur le support de substrat (4) après retrait du poussoir (9) par les ressorts de traction (8).

10. Utilisation du système de vide selon l'une des revendications 1 à 4 et du procédé selon l'une des revendications 5 à 9 pour le revêtement de CD, de DVD, de lentilles optiques et de verres de lunettes.

11. Utilisation du système de vide selon l'une des revendications 1 à 4 et du procédé selon l'une des revendications 5 à 9 pour le nettoyage de CD et de DVD.

12. Utilisation du système de vide selon l'une des revendications 1 à 4 et du procédé selon l'une des revendications 5 à 9 pour le traitement de surface par irradiation ionique.

13. Utilisation selon la revendication 12 pour le traitement de surface de disques durs.
